# EUROPEAN PATENT APPLICATION

(11) **EP 1 372 188 A1**
(43) Date of publication of application: **17.12.2003**
(21) Application number: 02701625.2
(22) Date of filing: 28.02.2002
(51) Int. Cl.: H01L 21/314

(54) **SOLID-STATE DEVICE AND ITS MANUFACTURING METHOD**

(30) Priority: 28.02.2001 JP 2001055033
(71) Applicant: KABUSHIKI KAISHA WATANABE SHOKO, Chuo-ku, Tokyo 103-0022 (JP); Sugino, Takashi, Toyonaka-shi, Osaka 560-0085 (JP)
(72) Inventor: SUGINO, Takashi, Toyonaka-shi, Osaka 560-0085 (JP); KUSUHARA, Masaki, KABUSHIKI KAISHA WATANABE SHOKO, Tokyo 103-0022 (JP); UMEDA, Masaru, KABUSHIKI KAISHA WATANABE SHOKO, Tokyo 103-0022 (JP)
(74) Representative: Dr. Weitzel & Partner
(86) International application number: JP0201839
(87) International publication number: WO02069382

(57) **Abstract**

The present invention provides a solid device having a layered structure inwhich a filmhaving a lowdielectric constant serves as an interlayer insulating film or a protective membrane which will hardly undergo separation, andmethod for fabrication thereof.

A boron-carbon-nitrogen film is used as interlayer insulating films 5A to 5C, and as a passivation membrane of a semiconductor device.

## Description

### Technical Field

The present invention relates to a solid device and fabrication thereof, specifically to a solid device having a layered structure comprising an interlayer insulating layer (s) or protective membrane(s), and fabrication thereof.

### Background Art

The solid device includes semiconductor integrated circuit (IC) elements, individual semiconductor elements, semiconductor laser devices, liquid crystal display devices, and the like. To process an ever-increasing large volume of data, solid devices capable of high-speed action are needed.

In the fabrication of semiconductor IC elements, silicon oxide films (relative dielectric constant ε being 4 or less) have been widely used as an interlayer insulating film disposed between adjacent wiring layers in a layered wiring structure. However, in the fabrication of next-generation IC elements for which high integration is required, the design limit becomes equal to or less than 0 .25 µm, and thus the relative wiring length is increased. Because wiring-delay becomes equal to or larger than gate-delay or a parameter characteristic with semiconductors with the increase of relative wiring length, it is necessary then to reduce the RC time constant of wiring. For this purpose, aluminum (specific resistance being 3 µΩ.cm) which has been used as a material of wires is being substituted for copper (specific resistance being 2 µΩ.cm). In accodance with this tendency, a demand is emergent for a new material having a lower dielectric constant than silicon oxide which can be used as a material of an interlayer film for insulating interposed metal wires in place of silicon oxide.

In recent years, a similar demand for a new material with a low dielectric constant to be used as interlayer insulating films and protective membranes is also sought in the fabrication of high speed electronics elements made of compound semiconductors to be used for mobile communication and fiber-optics based communication. Such a new material would also be profitably used in the fabrication of liquid crystal display devices which require high speed action, as well as in the formation of interlayer films for insulating interposedwires and of membranes for protecting thin-film transistors. It would also be desirable to apply protective membranes made of such a material on the end surfaces of a semiconductor laser device, because it would enhance the high-speed action of the device.

Inthisrespect,organic materialshave attracted attention because some of them have a comparatively low dielectric constant of ε < 3, but they are unstable under heat. On the other hand, trials have been made to process a silicon oxide film so that the film may be porous and have thereby a low dielectric constant. However, such a processed film, even though being conferred the desired property, poses new problems including insufficient mechanical strength. Against such a background, boron nitride (BN) has attracted attention because it has a comparatively high heat resistance and mechanical strength, and a low dielectric constant, and trials have been made to produce a BN material having a still lower dielectric constant.

Formation of a BN film has been achieved by plasma chemical vapor deposition (CVD) which results in the formation of a hexagonal crystal BN film having a relative dielectric constant ε of 3 or lower. However, the BN film is hygroscopic, andmoisture adsorbed to the film, in association with stresses present in the film, may cause cracks to develop in the film, or the BN film itself to be separated from the underlying substrate. Thus, introduction of BN materials in the fabrication of solid devices has been thought practically infeasible.

The present invention was proposed to give a solution to these problems, and aims to provide a solid device in which interlayer insulating films and protective membranes have a low dielectric constant and they are safely prevented from mechanical flaws such as separation, and a method for fabricating such a device.

### Disclosure of Invention

To solve the above problems, one aspect of the invention as described in Claim 1 is to provide a solid device which comprises a boron-carbon-nitrogen film as an interlayer insulating film or as a protective membrane.

Another aspect of the invention as described in Claim 2 is to provide a solid device in which the boron-carbon-nitrogen film is disposed between adjacent interlayer insulating films, or serves as a coating of the top or bottom surface of an interlayer insulating film.

Yet another aspect of the invention as described in Claim 3 is to provide a solid device as described in Claim 1 in which the boron-carbon-nitrogen film comprises at least one chosen from the group comprising an amorphous phase, crystal phase and crystal particle phase as a result of disturbed atomic coupling.

Yet another aspect of the invention as described in Claim 4 is to provide a solid device as described in Claim 1 in which the boron-carbon-nitrogen film comprises a boron-nitrogen bond having a boron nitride hexagonal crystal system.

Yet another aspect of the invention as described in Claim 5 is to provide a solid device as described in Claim 1 in which the born-carbon-nitrogen filmhas a relative dielectric constant of 3.0 or lower.

Yet another aspect of the invention as described in Claim 6 is to provide a method for fabricating a solid device comprising the steps of: placing a substrate upon which a film is to be formed in a nitrogen plasma atmosphere; and providing boron and carbon atoms to the substrate such that a boron-carbon-nitrogen film comprising disturbed atomic bonds in its structure is formed on the substrate.

### Brief Description of the Drawings

Fig. 1 gives a sectional view of a semiconductor device representing Example 1 of this invention.
Fig. 2 illustrates the steps for fabricating the semiconductor device of Example 1.
Fig. 3 gives a sectional view of a field-effect transistor representing Example 2 of this invention.
Fig. 4 illustrates the steps for fabricating the semiconductor device of Example 2.
Fig . 5 gives a sectional view of a semiconductor laser device representing Example 3 of this invention.
Fig. 6 is an equivalent circuit diagram of a liquid crystal display device representing Example 4 of this invention.
Fig. 7 gives a sectional view of a liquid crystal cell of the liquid crystal display device shown in Fig. 6.
Fig. 8 gives a sectional view of a semiconductor device representing Example 5 of this invention.
Fig. 9 gives a sectional view of a semiconductor device representing Example 6 of this invention.
Fig. 10 gives a sectional view of a semiconductor device representing Example 7 of this invention.

### Reference Numerals

- 1: silicon substrate
- 2: gate
- 3: contact
- 4: oxide membrane
- 5A-5C: interlayer insulating film
- 6A-6F: wiring metal
- 7: passivation membrane
- 21: gallium arsenide substrate
- 22: gallium arsenide active layer
- 23: source
- 24: drain
- 25: gate
- 26: insulating layer
- 31: gallium arsenide substrate
- 32, 34: aluminum-indium-phosphor cladding layer
- 33: indium-gallium-phosphor active layer
- 35, 36: metal electrode
- 37: anterior cavity end surface protective membrane
- 38: posterior cavity end surface protective membrane
- 41: thin-film transistor
- 42: liquid crystal cell
- 43: capacitor for signal accumulation
- 44: gate electrode line
- 45: drain electrode line
- 46: driving circuit element
- 51: glass substrate
- 52: gate electrode
- 53: gate insulating film
- 54: semiconductor layer
- 55: drain electrode
- 56: source electrode
- 57: protective membrane
- 58: pixel electrode
- 59: polarizing plate
- 60: liquid crystal
- 61: orientation membrane
- 62: opposite electrode
- 63: black matrix
- 64: color filter
- 65: polarizing plate
- 66: back light

### Best Mode for Carrying out the Invention

Examples of this invention will be described in detail below with reference to attached drawings.

### EXAMPLE 1

Example 1 representing a solid device of the invention is a semiconductor device and also relates to a method for fabricating such a semiconductor device.

The semiconductor device comprises interlayer insulating films. The interlayer insulating film includes insulating films for insulating electrodes and wires formed on a substrate constituting the semiconductor IC element, and membranes for protecting such circuit elements. The interlayer insulating film also includes insulating films and protective membranes for insulating and protecting devices such as transistors. The interlayer insulating film comprises single layered and multi-layered films.

Formation of a boron-carbon-nitrogen film will be described. Formation of the film is achieved by plasma CVD. A nitrogen gas stream is supplied on the surface of a substrate upon which a boron-carbon-nitrogen film is to be formed, and nitrogen plasma is allowed to develop on the upper layer of the nitrogen gas stream. Then, boron and carbon atoms are provided into a space between the nitrogen plasma and the surface of substrate . The nitrogen gas source consists only of nitrogen gas, instead of a compound such as ammonia which is a compound of nitrogen and hydrogen, thereby preventing the entry of other elements such as hydrogen into the reaction system. The sources supplying boron and carbon atoms consist of boron trichloride and methane gases, respectively. The temperature of the substrate is kept between room temperature and 400°C, and adjusted appropriately according to a given application.

A boron-carbon-nitrogen film has an insulating activity. Addition of carbon atoms to crystallizing boron nitride during the formation of a boron-carbon-nitrogen film disturbs bonding of the involved atoms, and distribution of electrons among them. Accordingly, electron polarization is also disturbed, which causes the dielectric constant of the resulting film to be reduced. This film is suitably used as an interlayer insulating film because of its low dielectric constant.

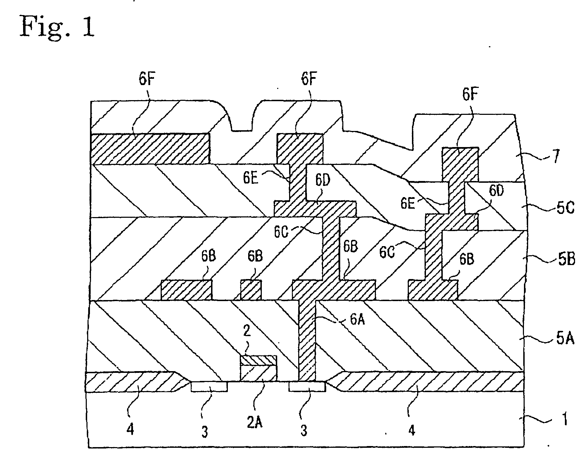

This invention will be described below with reference to an exemplary semiconductor device. A semiconductor device of Example 1 comprises a silicon substrate 1, gate 2, oxide membranes 2A, 4, contacts 3, interlayer insulating films 5A to 5C acting as interlayer insulating layers, wiring metals 6A to 6F, and a passivation membrane 7 acting as a protective membrane as shown in Fig. 1.

The silicon substrate 1 is a p-type silicon semiconductor substrate. The semiconductor element included herein is an MOS FET (metal oxide semiconductor field effect transistor) consisting of a gate 2, oxide membrane 2A and contacts 3. The MOSFET is isolated by formation of oxide membranes 4.

To construct a multi-layered wired structure on the MOSFET, a first interlayer insulating film 5A is formed over the silicon substrate 1, oxide membranes 4 andMOSFET. The first interlayer insulating film 5A is a boron-carbon-nitrogen film. The interlayer insulating film 5A is pattern-etched by photolithography. In cavities and a through-hole formed in the interlayer insulating film 5Aas a result of photo-etching, there are provided metal blots for wiring 6A, 6B. In the same manner, second and third interlayer insulating films 5B, 5C and metal blots for wiring 6C-6F are formed. The second and third interlayer insulating films 5B, 5C are made of a boron-carbon-nitrogen film similarly to the first interlayer film 5A.

On the top surface of the semiconductor device having the interlayer insulating film 5C andmetal blots for wiring 6F formed thereupon, a passivation membrane 7 is formed. The passivation membrane 7 is a boron-carbon-nitrogen membrane. The semiconductor device is configured as above.

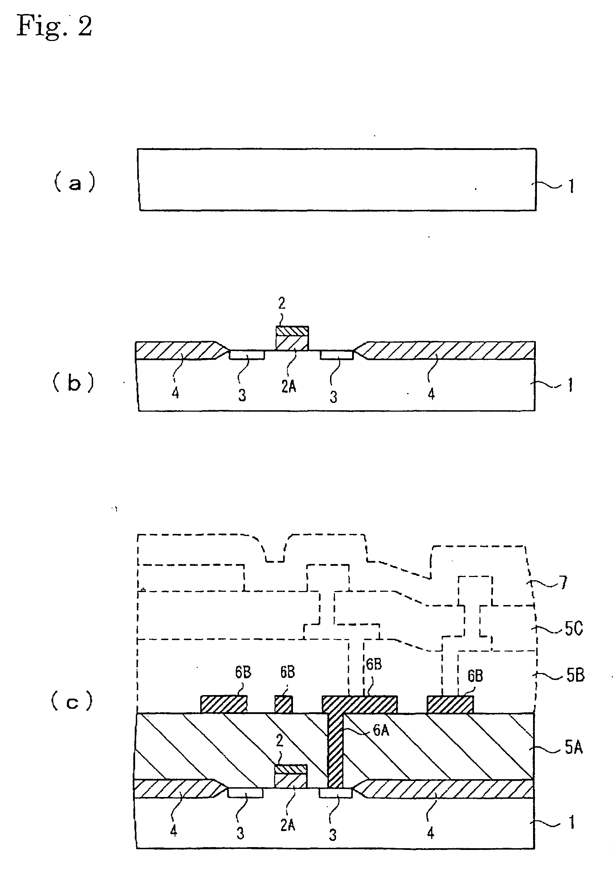

The semiconductor device configured as above is fabricated via following steps. An MOSFET as described above is prepared on a p-type silicon substrate 1 as shown in Fig. 2(a), using a conventional process based on thermal oxidation as shown in Fig. 2 (b). Then, an oxide membrane 4 is formed over the assembly using a LOCOS (local oxidation of silicon) process, to isolate the MOSFET.

Next, an interlayer insulating film 5A made of a boron-carbon-nitrogen film is formed by plasma CVD as shown in Fig. 2 (c). This is achieved as follows: the assembly is kept at 390°C; a nitrogen gas is introduced into the reactor to produce nitrogen plasma there; boron trichloride and methane gases are decomposed; and the relevant atoms are allowed to reach with each other to form a boron-carbon-nitrogen film. The reaction chamber is kept at a pressure of 0.6 Torr, and a bias voltage of -150 V is applied to the substrate. As a result, a film in which crystal particles with a size of about 5 nm comprising 40 wt. % boron, 20 wt. % carbon and 40 wt. % nitrogen are intermingled with amorphous domains is obtained as the interlayer insulating film 5A.

The interlayer insulating film 5A is then pattern-etched byphotolithography. Apattern of cavities and a hole are formed in the interlayer insulating film 5A by reactive ion etching using boron trichloride and nitrogen gases. Then, copper is plated over the cavities and hole, and the surface is polished chemically andmechanically to be flat, to produce thereby wiring metal specks 6A, 6B.

In the same manner, interlayer insulating films 5B, 5C are overlaid, and wiring metal specks 6C to 6F are formed on and through them. Finally, the passivation membrane 7 is laid over the assembly. The passivation membrane 7 may be made of a boron-carbon-nitrogen film as the same as the interlayer insulating films 5A to 5C.

The semiconductor device prepared as above has a following characteristic. Firstly, the same film with the interlayer insulating film 5 is formed on a metal substrate under the same condition, an electrode is formed on the film, and the dielectric constant of the film is determined. It is found as a consequence that the film has a dielectric constant κ = 2.5. This is far lower than the dielectric constant of a conventional SiO₂ film, that is, k = 4. It also has a considerably high resistance of 10¹⁰ Ωcm.

In Example 1, such an insulating film as above having a low dielectric constant and being resistant to peeling-off is used as a material of the interlayer insulating films 5A to 5C, and of the passivation membrane 7.

Further, Example 1 incorporates, as a material of the interlayer insulating films 5A-5C, a film in which crystal particles having a size of about 5 nm are intermingled with amorphous domains. However, the appropriate size of crystal particles and their content are not limited to the above. For example, a polycrystal film which only comprises crystal particles and particle interfaces is included in this invention. The acceptable crystal particles may include ones that have a size sufficiently small to comprise only several atoms bonded together.

With regard to the insulating film incorporated in Example 1, it is estimated based on infrared absorption that the crystal particles developed therein are mainly constituted with those having a boron nitride hexagonal system. However, a film in which a cubic system prevails instead of the hexagonal system may be used. The relative contents of boron, carbon and nitrogen are not limited to the values mentioned above with respect to

### Example 1.

### EXAMPLE 2

In Example 2, the solid device of the invention is a field effect transistor, and the method of the invention relates to the fabrication of such a transistor. In Example 2, interlayer insulating films are used for protecting the active layer of a field effect transistor and for isolating active layers interposed between electrodes as well as electrode metals and wiring metals.

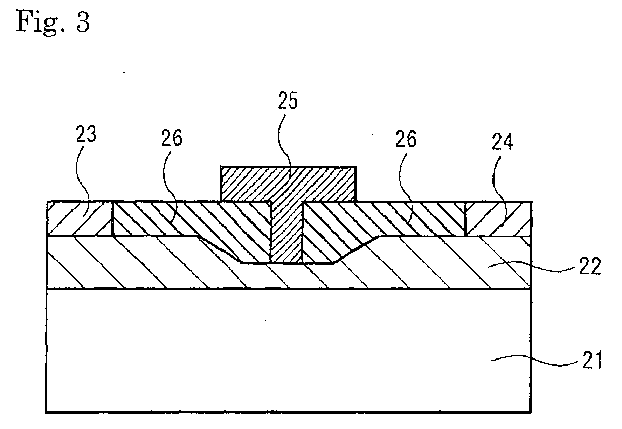

The invention will be described below with reference to an exemplary field-effect transistor. The field-effect transistor of Example 2 is a gallium arsenide MESFET (metal semiconductor field-effect transistor) which comprises a gallium arsenide substrate 21, a gallium arsenide active layer 22, a source 23, a drain 24, a gate 25 and insulating layers 26 as shown in Fig. 3.

The gallium arsenide substrate 21 is a semi-insulating substrate. A gallium arsenide active layer 22 is formed on the gallium arsenide substrate 21. On the gallium arsenide active layer 22 are formed the source 23 and drain 24 as ohmic electrodes, and the short key connection electrode is set as a gate 25. Thus, an MESEFT is formed. On exposed gaps of the gallium arsenide active layer 22 between the gate 25 and source 23 and between the gate 25 and drain 24 formed are insulating layers 26.

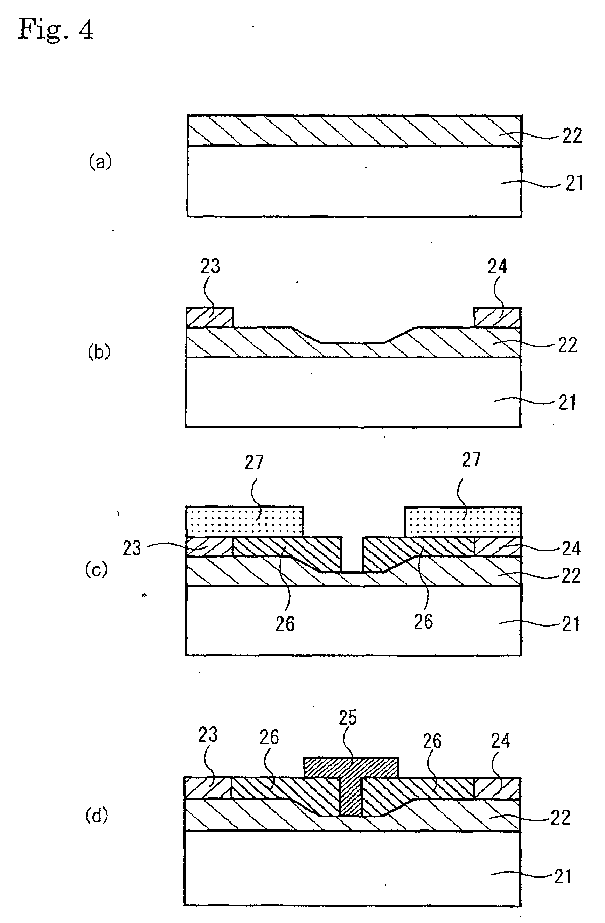

Preparation of the field-effect transistor configured as described above is achieved via following steps. An n-type gallium arsenide.active layer 22 (having an electron density of 1 × 10¹⁷ cm⁻³ and thickness of 1 µm) is deposited on the semi-insulating gallium arsenide substrate 21 by organic metal vapor deposition as shown in Fig. 4(a). After deposition of the gallium arsenide active layer 22, a compound of Au-Ge-Ni is deposited on the assembly by electron beam deposition to form a film 500 nm in thickness thereupon. Later, the assembly was thermally treated at 42°C for five minutes. Through this process, a source 23 and drain 24 are attached as ohmic contacts to the assembly. Then, the active layer 22 is selectively thinned between the source 23 and drain 24, to form a recess there.

Finally, a gate 25 is formed. Formation of the gate 25 proceeds as follows. Firstly, an insulating layer 26 with a thickness of 500 nm is formed on the active layer 22 between the source 23 and drain 22. Formation of the insulating layer 26 is achieved by plasma assisted vapor deposition using boron trichloride, nitrogen and methane gases as gas sources. The thus formed insulating layer 26 is a boron-carbon-nitrogen film.

Later, a slit with a width of 0.3 µm is formed through the insulating layer 26 over the recess by reactive ion etching using boron trichloride and nitrogen as shown in Fig. 4(c). Then, photolithography is introduced again to form resist membranes 27. A Ti-Pt compound is deposited over the resist membranes 27 by electron beam vapor deposition, and a lift-off step is introduced to form a gate 25 as shown in Fig. 4(d).

The thus prepared gallium arsenide MESFET incorporating insulating films 26 has an improved frequency characteristic as compared with an element incorporating an SiN film as the insulating films.

The gallium arsenide MESFET of Example 2 incorporates insulating films made of the material of the invention, and the same insulating film may be profitably used as in Example 2 in fabrication of indium phosphate MESFETs and gallium nitride MESFETs.

Although Example 2 has a single layer of boron-carbon-nitrogen film formed on the active layer, the film may have a bi-layered or multi-layered structure comprising other films in addition to theboron-carbon-nitrogen film, asmentioned earlier with respect to Example 1.

### EXAMPLE 3

In Example 3, the solid device of the invention is a semiconductor laser device, and the method of the invention relates to the fabrication of such a semiconductor laser device.

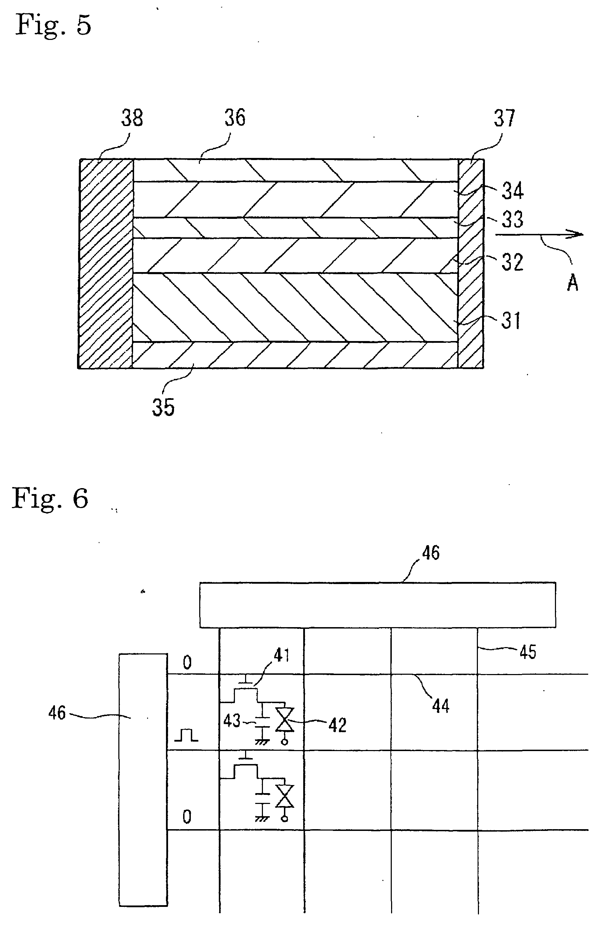

The semiconductor laser device of Example 3 comprises, as shown in Fig. 5, a gallium arsenide substrate 31, aluminum-indium-phosphor cladding layers 32, 34, an indium-gallium-phosphor active layer 33, metal electrodes 35, 36, and an anterior cavity protective membrane 37 and posterior cavity protective membrane 38.

Preparation of the semiconductor laser device configured as above is achieved via following steps. The aluminum-indium-phosphor cladding layer 32, indium-gallium-phosphor active layer 33, and aluminum-indium-phosphor cladding layer 34 are grown by organic metal chemical vapor deposition on the gallium arsenide substrate 31 to produce a layered structure with double hetero-junctions . A stripe is left over the double hetero-junctions, and aluminum-indium-phosphor layers are again grown on both sides of the stripe to produce a stripe laser device. The indium-gallium-phosphor active layer 33 is allowed to have a quantum well structure. Then, a metal electrode 35 is placed on the gallium arsenide substrate 31 and another metal electrode 36 on the surface of grown layers. A cavity is formedby cleavage .

Finally, an anterior cavity protective membrane 37 is formed on the frontal end surface of the cavity and a posterior cavity protective membrane 38 on the rear end surface of the cavity. The anterior cavity end surface from which a laser beam A emanates has a low reflectance while the posterior cavity end surface has a high reflectance, so that laser can be efficiently emitted from the frontal end surface. For this purpose, the anterior cavity protective membrane 37 is made of a single layered boron-carbon-nitrogenfilm, and the posterior cavity protective membrane 38 has a multi-layered structure comprising boron-carbon-nitrogen and silicon nitride films.

To put it more specifically, formation of the anterior and posterior cavity protective membranes 37, 38 is achieved as follows. Firstly, an anterior cavity protective membrane is formed by plasma CVD. The assembly is kept at 390°C; a nitrogen gas is introduced into the reactor to produce nitrogen plasma there; boron trichloride and methane gases are decomposed; and the relevant atoms are allowed to reach with each other to form a boron-carbon-nitrogen film. The reaction chamber is kept at a pressure of 0.6 Torr, and a bias voltage of -150 V is applied to the substrate. As a result, a film in which crystal particles with a size of about 5 nmcomprising 40 wt. % boron, 20 wt.% carbon and 40 wt.% nitrogen are intermingled with amorphous domains is obtained to serve as the anterior cavity protective membrane 37. Formation of a posterior cavity protective membrane 38 is achieved as follows. Firstly, a boron-carbon-nitrogen film is formed in the same manner as described above. Next, boron trichloride and methane gases are substituted for a silane gas, and a silicon nitride film is formed. This process is repeated until a four-layered structure is obtained, which comprises four layers of boron-carbon-nitrogen and silicon nitride films alternately repeated.

In contrast with the conventional semiconductor laser device where the protective membranes are constituted with amorphous silicon and aluminamembranes, the semiconductor laser device of this invention prepared as described above has both end surfaces formed by boron-carbon-nitrogen films, and thus its high speed action is improved, particularly its reliability in a high output range is greatly improved. This is because the boron-carbon-nitrogen membrane has such a low dielectric constant that it insures a high-speed action. Moreover, because the boron-carbon-nitrogen membrane has a forbidden band which is broader than the photon energy range of a laser beam whose wavelength is in an infra-red visible region, no absorption loss occurs at the end surfaces. It is also excellent in thermal transmission. Thus, the laser device will have an improved reliability.

Although Example 3 is a semiconductor laser device incorporating gallium-indium-phosphor as a material of its active layer (indium-gallium-phosphor active layer 33), the boron-carbon-nitrogen film of this invention which serves as protective end surface membranes in Example 3 may also be incorporated, for the same purpose, into a gallium nitride based laser device emitting a blue-violet beam, and indium-gallium-arsenic based laser device emitting an infra-red beam.

Although, with Example 3, the posterior cavity protective membrane is constituted with a system of boron-carbon-nitrogen and silicon nitride films, the silicon nitride film may be substituted for any other insulating films having a different refractive index from that of the boron-carbon-nitrogen film. Further, the posterior cavity protective membrane may have a multi-layered structure comprising two boron-carbon-nitrogen films, with the composition of boron, carbon and nitrogen of one film being made different from that of the other film so that the resulting boron-carbon-nitrogen film system has two different refractive indices.

### EXAMPLE 4

In Example 4, the solid device of the invention is a liquid crystal display device. In fabrication of a liquid crystal display device where thin-film transistors and IC elements including a driving circuit are formed on a glass substrate, it is necessary to introduce interlayer insulating films for insulating elements, and membranes for protecting the elements. Particularly, because the liquid crystal display device requires long wires to be extended across its displaypanel, it is important to keep the wiring delay as short as possible. For this purpose, techniques introduced with respect to Examples 1 and 2 are also employed in fabrication of the liquid crystal display device of Example 4.

An exemplary liquid crystal displaydevice will be described in detail. The liquid crystal display device of Example 4 is an active matrix type liquid crystal display device, and its driving portion comprises, as shown in the equivalent circuit diagram of Fig. 6, thin-film transistors 41, liquid crystal cell 42, signal accumulating capacitors 43, gate electrode lines 44, drain electrode lines 45, and a driving circuit element 46 responsible for the setting of scan and address lines.

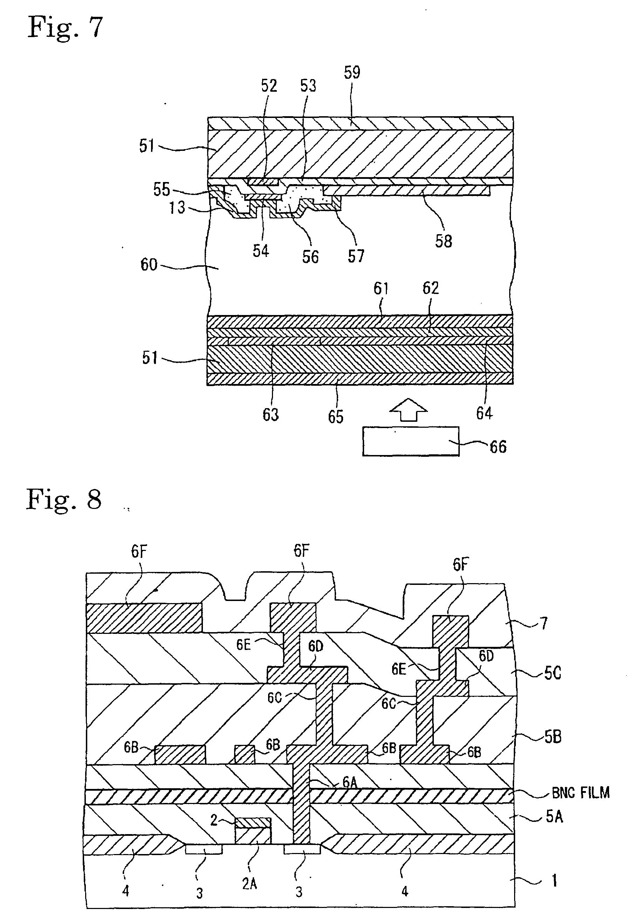

Each liquid crystal cell 42 contains a thin-film transistor, and comprises, as shown in Fig. 7, a glass substrate 51, a gate electrode 52, a gate insulating film 53, a semiconductor layer (amorphous silicon layer) 54, a drain electrode 55, a source electrode 56, a protective membrane 57, and a pixel electrode (ITO or indium tin oxide) 58 . In addition to the liquid crystal cells, the device comprises a polarizing plate 59, a liquid crystal 60, an orientation membrane 61, an opposite electrode 62 (ITO), a black matrix 63, a color filter 64, another polarizing plate 65, and a back light 66.

The liquid crystal display device comprises a thin-film transistor 41 for each pixel. According to the liquid crystal display device, leads necessary for scanning and address designation, that is, gate electrode lines 44 and drain electrode lines 45 are arrangedverticallyandhorizontally, respectively. These lines require interlayer insulating films for their isolation. Leads arranged in a liquid crystal display device are longer than those in a semiconductor IC element, and thus the liquid crystal display device tends to have a longer wire delay than the semiconductor IC element. To moderate the flaw inherent to the liquid crystal display device, it is necessary to use a substance with a low dielectric constant as a material of interlayer insulating films because the device incorporating such interlayer insulating films can insure a high-speed operation. It is also desirable to prepare the membrane 57 for protecting each thin-film transistor 41 from a film of a low dielectric constant.

As described above, if the boron-carbon-nitrogen film is used as an interlayer insulating film for insulating not only each thin-film transistor responsible for the direct activation of a pixel, and its adjacent circuit elements, but also leads connecting an array of pixels, it will be possible to minimize wire delay which will bring about a great profit.

Examples 1 to 4 have been detailed above. However, the constitution of the solid device of the invention is not limited to those examples, and any design modifications of those examples are included in this invention as long as they do not depart from the essence of this invention.

For example, Examples 1 and 2 have been described with reference to a single electronic circuit element or to an IC element where the boron-carbon-nitrogen film is incorporated as a material of interlayer insulating films and protective membranes. Example 4 has been described with reference to a liquid crystal display device which comprises thin-film transistors formed on a glass substrate responsible for the activation of individual pixels, and a signal processing IC. Although the latter example is different from the former in the material of the substrate, the two kinds of examples are the same in that they require interlayer insulating films for insulating leads connecting different elements, and membranes for protecting the elements. Thus, the boron-carbon-nitrogen film as used in Examples 1 and 2 is similarly profitably used in Example 4.

### EXAMPLE 5

Example 5 relates to a method for fabricating a solid device as representedbyExample 1 wherein aboron-carbon-nitrogen (BNC) film is formed between adjacent interlayer insulating films.

The solid device comprises a silicon substrate 1, a gate 2, oxide membranes 2A, 4, contacts 3, interlayer insulating films 5A to 5C which act as interlayer insulating layers, wiring metals 6A to 6F, and a passivation membrane 7 as shown in Fig. 8.

The interlayer insulating films 5A to 5C may be formed of an insulating film (e.g., boron-carbon film or Si₃Ni₄ film) other than the boron-carbon-nitrogen film.

### EXAMPLE 6

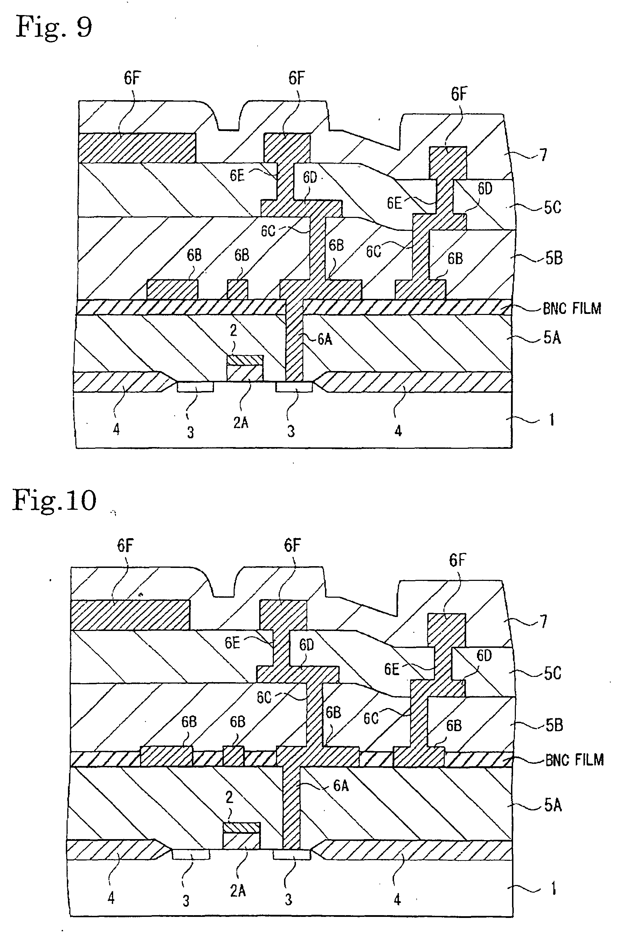

Example 6 relates to a method for fabricating a solid device as represented by Example 1 wherein a BNC film is formed on the top surface of one interlayer insulating film as shown in Fig. 9.

### EXAMPLE 7

Example 7 relates to a method for fabricating a solid device as represented by Example 1 wherein the BNC film is formed on the bottom surface of another interlayer insulating film as shown in Fig. 10.

### Industrial Applicability

As described above, according to the invention, a boron-carbon-nitrogen film or a film with a low dielectric constant of 3 or less is obtained by plasma CVD. When the film is incorporated in a device having a multilayered structure for insulating multilayered wires or for protecting elements contained therein, it will be possible to prevent the peeling-off of wires, improve their adherence to the structure, and to effectively provide a solid device which has a reduced wiring delay.

The soliddevicemaybe usedas a key device in the manufacture of high performance information processing systems, communication systems, control systems, etc., as well as of computers.

## Claims

1. A solid device comprising a boron-carbon-nitrogen film as an interlayer insulating film or a protective membrane.

2. A solid device in which a boron-carbon-nitrogen film is disposed between adjacent interlayer insulating films, or serves as a coating of the top or bottom surface of an interlayer insulating film.

3. A solid device as described in Claim 1 or 2 in which the boron-carbon-nitrogen film comprises at least one chosen from the group comprising an amorphous phase, crystal phase and crystal particle phase as a result of disturbed atomic bonding.

4. A solid device as described in Claim 1 or 2 in which the boron-carbon-nitrogen film comprises a boron-nitrogen bond having a boron nitride hexagonal crystal structure.

5. A solid device as described in Claim 1 or 2 in which the born-carbon-nitrogen filmhas a relative dielectric constant of 3.0 or lower.

6. A method for fabricating a solid device comprising the steps of:
placing a substrate upon which a film is to be formed in a nitrogen plasma atmosphere; and
providing boron and carbon atoms to the substrate such that a boron-carbon-nitrogen film comprising disturbed atomic bonds in its structure is formed on the substrate.
